(19) Europäisches Patentamt
European Patent Office
Office européen des brevets

(11) Veröffentlichungsnummer: **0 212 482 B1**

# (12) EUROPÄISCHE PATENTSCHRIFT

(45) Veröffentlichungstag der Patentschrift: **19.04.89**

(51) Int. Cl.⁴: **G03F 7/08**, G03F 7/26

(21) Anmeldenummer: **86110953.6**

(22) Anmeldetag: **08.08.86**

(54) **Verfahren zur Herstellung negativer Bilder aus einem positiv arbeitenden Photoresist.**

(30) Priorität: **12.08.85 US 764700**

(43) Veröffentlichungstag der Anmeldung: **04.03.87 Patentblatt 87/10**

(45) Bekanntmachung des Hinweises auf die Patenterteilung: **19.04.89 Patentblatt 89/16**

(84) Benannte Vertragsstaaten: **AT DE FR GB NL**

(56) Entgegenhaltungen:
**EP-A- 0 073 444**
**DE-A- 2 322 230**
**GB-A- 1 494 640**
**US-A- 4 247 616**
**US-A- 4 600 683**

**PATENT ABSTRACTS OF JAPAN, Band 5, Nr. 96 (P-67)[768], 23. Juni 1981; & JP-A-56 40 823 (OKI DENKI KOGYO K.K.) 17-04-1981**
**IBM TECHNICAL DISCLOSURE BULLETIN, Band 13, Nr. 4, September 1970, Seite 903, New York, US; H.A. LEVINE: "Positive-resist speed enhancing"**

(73) Patentinhaber: **HOECHST CELANESE CORPORATION, Route 202-206 North, Somerville, N.J. 08876(US)**

(72) Erfinder: **Spak, Mark A., 11 Lafayette Avenue, Edison, N.J. 08837(US)**
Erfinder: **Durham, Dana, RD No. 1, Box 372, Bloomsbury, N.J. 08804(US)**
Erfinder: **Mammato, Donald, Fawn Drive RD No. 1, Lebanon, N.J. 08833(US)**
Erfinder: **Jain, Sangya, 988 Robin Road, Somerville, N.J. 08876(US)**

(74) Vertreter: **Euler, Kurt Emil, Dr. et al, KALLE Niederlassung der Hoechst AG Rheingaustrasse 190 Postfach 3540, D-6200 Wiesbaden 1(DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 212 482 B1

ACTORUM AG

**Beschreibung**

Die vorliegende Erfindung betrifft ein Verfahren zur Herstellung negativer Bilder aus einem positiv arbeitenden Photoresist, beispielsweise aus einem strahlungsempfindlichen Photoresistgemisch, in dem in wäßrigen Alkalien lösliche Harze und Naphthochinondiazide als lichtempfindliche Verbindungen enthalten sind.

Die Herstellung positiv arbeitender Photoresists ist bekannt und beispielsweise in US-A 3 666 473, 4 115 128 und 4 173 470 beschrieben. Dazu gehören alkalilösliche Phenol-Formaldehyd-Novolakharze in Verbindung mit lichtempfindlichen Substanzen, in der Regel substituierten Naphthochinondiazidverbindungen. Die Harze und lichtempfindlichen Verbindungen werden in einem organischen Lösemittel oder Lösemittelgemisch gelöst und in dünner Schicht auf einen für den jeweiligen Zweck geeigneten Schichtträger aufgetragen.

Die Harzkomponente dieser Photoresistgemische ist in wäßrig-alkalischen Lösungen löslich, doch übt die lichtempfindliche Verbindung auf Naphthochinonbasis eine lösungshemmende Wirkung auf das Harz aus. Bei Belichtung ausgewählter Bereiche des beschichteten Trägers mittels aktinischer Strahlung erfährt die lichtempfindliche Verbindung jedoch eine belichtungsbedingte strukturelle Umwandlung und die Löslichkeit der belichteten Schichtbereiche wird größer als die der unbelichteten Bereiche.

Aufgrund dieses unterschiedlichen Lösungsverhaltens werden die belichteten Bereiche der Photoresistschicht beim Eintauchen des Schichtträgers in eine alkalische Entwicklerlösung abgelöst, während die nicht belichteten Bereiche im wesentlichen unverändert erhalten bleiben, so daß auf dem Schichtträger ein positives Reliefbild erhalten wird.

In den meisten Fällen wird der belichtete und entwickelte Schichtträger noch mit einer Ätzlösung behandelt. Die Photoresistschicht schützt die beschichteten Bereiche des Schichtträgers vor dem Ätzmittel, das folglich nur auf die schichtfreien Bereiche, d.h. im Fall eines positiv arbeitenden Photoresists, auf die mittels aktinischer Strahlung belichteten Bereiche, einwirken kann. Auf diese Weise wird auf dem Schichtträger ein Ätzbild erzeugt, das der Maske, Schablone oder sonstigen Vorlage entspricht, durch die vor dem Entwickeln belichtet wurde.

Das nach dem beschriebenen Verfahren auf dem Schichtträger erzeugte Photoresistreliefbild ist für verschiedene Anwendungszwecke geeignet, z.B. für die Herstellung von Belichtungsmasken oder von Halbleiterbauelementen.

Zu den Kriterien, nach denen die Eignung eines Photoresistgemisches für kommerzielle Zwecke beurteilt wird, zählen die Lichtempfindlichkeit des Photoresists, der Kontrast nach der Entwicklung, die Resistauflösung und die Haftung der Resistschicht auf dem Schichtträger.

Die Resistauflösung betrifft das Vermögen eines Photoresistsystems, auch die feinsten Linien und Zwischenräume einer für die Belichtung verwendeten Maske wiederzugeben, wobei die belichteten und entwickelten Bereiche ein hohes Maß an Flankensteilheit aufweisen.

Auf vielen industriellen Einsatzgebieten, insbesondere bei der Herstellung von Halbleiterbauelementen, muß der eingesetzte Photoresist auch noch bei sehr geringen Strukturbreiten eine hohe Auflösung ergeben (1 µm und weniger). Diese Eigenschaft, d.h., die Fähigkeit zur Wiedergabe von Bildstellen sehr geringer Abmessungen, in einem Größenbereich von 1 µm oder weniger, ist für die großtechnische Herstellung integrierter Schaltungen auf Siliciumscheiben und ähnlichen Bauteilen von entscheidender Bedeutung.

Die Integrationsdichte auf einem solchen Chip kann beim Einsatz photolithographischer Verfahren nur durch eine Steigerung des Auflösungsvermögens des Photoresists erhöht werden.

Photoresists werden allgemein in positiv und negativ arbeitende Photoresists eingeteilt. Ein negativ arbeitendes Photoresistgemisch zeichnet sich dadurch aus, daß die bei der bildmäßigen Belichtung vom Licht getroffenen Bereiche gehärtet werden. Sie bilden nach dem Entfernen der unbelichteten Bereiche mittels eines geeigneten Entwicklers die Bildstellen des Photoresists. Bei positiv arbeitenden Photoresists bilden dagegen die unbelichteten Bereiche die Bildstellen. Die vom Licht getroffenen Bereiche werden durch die Belichtung in wäßrig-alkalischen Entwicklern löslich. Während für die großtechnische Herstellung gedruckter Schaltungen überwiegend negativ arbeitende Photoresists verwendet werden, zeichnen sich positiv arbeitende Photoresists durch ein viel höheres Auflösungsvermögen aus und ermöglichen die Wiedergabe kleinerer Bildelemente. Daher werden zur Produktion von Schaltungen mit hoher Integrationsdichte in üblicher Weise positiv arbeitende Photoresists eingesetzt.

In der Praxis ist es für eine Reihe von Anwendungsgebieten vorteilhaft, einen positiv arbeitenden Photoresist auf Chinondiazidbasis mit hohem Auflösungsvermögen so umzuwandeln, daß er für eine negative Verarbeitung geeignet ist.

Das Interesse an einem Bildumkehrverfahren besteht aufgrund des Nutzens, den ein solches Verfahren für die Herstellungspraxis mit sich bringt. Die Vorteile der Bildumkehrung liegen u.a. darin, daß kein doppelter Satz komplementärer Masken für die positive und negative Bebilderung mehr benötigt wird, daß ein größerer Auflösungsbereich und Verarbeitungsspielraum als bei ausschließlich positiver Bebilderung vorhanden ist, und daß das Auftreten stehender Wellen reduziert und größere Wärmebeständigkeit erreicht wird.

In diesem Zusammenhang wurden bereits zahlreiche Verfahren zur Bildumkehrung vorgeschlagen, wie z.B. S.A. MacDonald et al., "Image Reversal: The Production of a Negative Image in a Positive Photoresist", S. 114, IBM Research Disclosure, 1982; E. Alling et al., "Image Reversal of Positive Photoresist. A New Tool for Advancing Integrated Circuit Fabrication", Journal of the Society of Photo-Imaging Engineers, Vol. 539, S. 194, 1985; M.V. Buzuev et al., "Producing a Negative Image on a Positive Photoresist", SU No. 1 109 708; DE-PS 2 529 054, US-PS 4 104 070, DE-OS 3 325 022, entsprechend US-PS 4 581 321 und DE-OS 3 325 023, entsprechend US-PS 4 576 901.

Mit jedem dieser Verfahren sind jedoch auch Nachteile verbunden. Ein Hauptnachteil der gegenwärtig angewendeten Bildumkehrverfahren liegt darin, daß ein zusätzlicher Verfahrensschritt erforderlich ist, der entweder die Behandlung mit salzbildenden Verbindungen oder den Einsatz von besonders energiereichen Belichtungsquellen, wie z.B. Elektronenstrahlen, vorsieht.

Es war Aufgabe der vorliegenden Erfindung, ein Verfahren zur Herstellung negativer Bilder aus einem positiv arbeitenden Photoresist zu schaffen, das die Nachteile der bekannten Verfahren nicht aufweist und in einfachen Verfahrensschritten sowohl positive als auch negative Bebilderung ermöglicht und sich durch höhere Auflösung und größere Wärmebeständigkeit auszeichnet. Es war auch Aufgabe der Erfindung, neue vernetzende Substanzen für das Verfahren anzugeben.

Die Lösung dieser Aufgabe geht aus von einem Verfahren der eingangs genannten Art, und sie ist gekennzeichnet durch die Kombination folgender Verfahrensschritte:

A) Herstellung eines lichtempfindlichen Gemisches, bestehend aus

a) etwa 1 bis 25 Gewichtsprozent, bezogen auf die festen Bestandteile des Gemisches, einer lichtempfindlichen Verbindung der allgemeinen Formel I

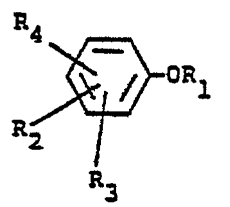

(I)

worin

$R_1$ – 1,2-Benzochinon-(2)-diazid-4-sulfonyl-, 1,2-Naphthochinon-(2)-diazid-4-sulfonyl- oder 1,2-Anthrachinon-(2)-diazid-4-sulfonyl,

$R_2$, $R_3$, $R_4$ – gleich oder verschieden sind und Wasserstoff, $R_5$, $-OR_6$ oder $-CO-R_7$,

$R_5$ und $R_7$ – Alkyl, Aryl oder Aralkyl und

$R_6$ – Wasserstoff, Alkyl, Aryl, Aralkyl oder $R_1$ bedeuten,

b) etwa 75 bis 99 Gewichtsprozent, bezogen auf die festen Bestandteile des Gemisches, eines Novolaks und/oder Polyvinylphenol-, insbesondere Poly-p-vinylphenol-Harzes,

c) etwa 0,5 bis etwa 20 Gewichtsprozent, bezogen auf die festen Bestandteile des Gemisches, aus einem Vernetzer besteht, der in Gegenwart von Säure, die aus den Lichtzersetzungsprodukten entsteht, die Fähigkeit besitzt, das Harz nach b) zu vernetzen und

d) einer ausreichenden Menge an Lösungsmittel, um die vorstehenden Verbindungen zu lösen,

B) Beschichten eines Schichtträgers mit dem lichtempfindlichen Gemisch nach A),

C) Vortrocknen der Lösung auf Temperaturen im Bereich von 20 bis 100°C, bis das Lösungsmittel im wesentlichen verdunstet ist,

D) bildliches Belichten der lichtempfindlichen Schicht mit aktinischer Strahlung,

E) Tempern der belichteten Schicht auf Temperaturen im Bereich von wenigstens 95°C bis etwa 160°C innerhalb von 10 Sekunden und mehr, in welcher Zeit die Vernetzung erfolgt,

F) Entfernen der unbelichteten Bereiche der Schicht mit einem alkalischen Entwickler.

In bevorzugter Ausführung des erfindungsgemäßen Verfahrens wird als lichtempfindliche Verbindung 2,3,4-Trihydroxy-benzophenon-1,2-naphthochinon-(2)-diazid-4-sulfonsäuretrisester verwendet. Das Verfahren wird vorzugsweise so durchgeführt, daß man das Tempern bei Temperaturen im Bereich von etwa 95 bis etwa 150°C, insbesondere von etwa 112 bis etwa 120°C, und innerhalb von etwa 10 bis etwa 90 Sekunden durchführt.

Als Vernetzer verwendet man beispielsweise eine Verbindung der allgemeinen Formel II

$(R_1O-CHR_3)_n-A-(CHR_3-OR_2)_m$, (II)

in der A = $-B-$ oder $-B-Y-B-$ ist und

B = einen gegebenenfalls substituierten einkernigen aromatischen aromatischen Kohlenwasserstoff oder eine Sauerstoff oder Schwefel enthaltende heterocyclische aromatische Verbindung darstellt,

Y = eine Einfachbindung, $C_1$ bis $C_4$-Alkylen oder Alkylendioxy, deren Ketten durch Sauerstoffatome unterbochen sein können, $-O-$, $-S-$, $-SO_2-$, $-CO-$, $-CO_2-$, $-O-CO_2-$, $-CONH-$ oder Phenylendioxy bedeutet,

$R_1$ und $R_2$ – Wasserstoff, $C_1$ bis $C_6$-Alkyl, Cycloalkyl-, gegebenenfalls substituiertes Aryl, Aralkyl oder Acyl ist,

$R_3$ – Wasserstoff, $C_1$ bis $C_4$-Alkyl oder gegebenenfalls substituiertes Phenyl,
n – 1 bis 3 und
m – 0 bis 3, wobei n+m mindestens 2 ist,
bedeuten.

Hierdurch wird erreicht, daß man ein verbessertes Verhältnis von Belichtungsenergien zu resultierender Strichbreiten, einen größeren Verarbeitungsspielraum, eine bessere Bildauflösung nach der Entwicklung, eine weitgehende Beseitigung von als 'reflective notching' bezeichneten unerwünschten Reflektionseffekten, eine erhöhte Lichtempfindlichkeit, eine größere thermische Stabilität des erhaltenen Bildes und eine bessere Haftung des Photoresists auf den allgemein verwendeten Schichtträgern erreicht. Weiterhin erzielt man durch die erfindungsgemäße Verfahrensführung den Vorteil gegenüber den bekannten Verfahren, daß der Verfahrensschritt der abschließenden ganzflächigen Aussetzung der Schicht aktinischer Strahlung vor der Entwicklung unterbleibt.

Für die Herstellung der erfindungsgemäßen Photoresiststruktur wird zunächst eine Schicht aus dem vorstehend beschriebenen lichtempfindlichen Gemisch auf einen geeigneten Schichtträger aufgetragen und getrocknet. In dem lichtempfindlichen Gemisch sind ein Lösemittel, ein Vernetzungsmittel, ein harzartiges Bindemittel und eine lichtempfindliche Verbindung mit 1,2-Chinondiazid-4-sulfonylgruppen enthalten. Geeignete Bindemittel sind z.B. Novolake, Polyvinylphenole, insbesondere Poly-p-vinylphenole.

Die Herstellung von Novolakharzen, die als Bindemittel für lichtempfindliche Gemische geeignet sind, ist bekannt. Sie wird beispielsweise von A. Knop und W. Scheib in "Chemistry and Application of Phenolic Resins", Kap. 4, Springer-Verlag, New York, 1979, beschrieben. Aus US-A 3 869 292 und 4 439 516 ist die Verwendung von Polyvinylphenolen und p-Vinylphenolen bekannt. Auch die Verwendung von o-Chinondiaziden ist dem Fachmann bekannt und beispielsweise beschrieben in J. Kosar, "Light Sensitive Systems", Kap. 7.4., John Wiley & Sons, New York, 1965.

Diese lichtempfindlichen Verbindungen, die auch einen Bestandteil der erfindungsgemäßen Photoresist-Gemische bilden, werden vorzugsweise aus der Gruppe der lichtempfindlichen Verbindungen auf der Basis substituierter o-Naphthochinondiazide ausgewählt, wie sie üblicherweise in den Rezepturen für positiv arbeitende Photoresistgemische verwendet werden. Geeignete Verbindungen dieser Art sind beispielsweise in den US-A 2 797 213, 3 106 465, 3 148 983, 3 130 047, 3 201 329, 3 785 825 und 3 802 885 beschrieben.

Als lichtempfindliche Verbindung wird ein 1,2-Chinondiazid-4-sulfonsäureester eines Phenolderivates eingesetzt. Offensichtlich ist im Rahmen der vorliegenden Erfindung nicht die Anzahl anellierter Ringe, sondern die Stellung der Sulfonylgruppe ausschlaggebend, d.h., es können Benzochinone, Naphthochinone oder Anthrachinone verwendet werden, doch müssen in jedem Fall der Sauerstoff in der 1-Stellung, die Diazogruppe in der 2-Stellung und die Sulfonylgruppe in der 4-Stellung angeordnet sein. Auch die Art der phenolischen Komponente, mit der das Diazid verbunden ist, scheint nicht von Bedeutung zu sein. So kann es sich beispielsweise um ein Cumylphenolderivat gemäß US-A 3 640 992, oder um ein Mono-, Di- oder Trihydroxyphenylalkylketon oder ein Mono-, Di- oder Trihydroxybenzophenon gemäß US-A 4 499 171 handeln.

Als lichtempfindliche Verbindungen sind beispielsweise einsetzbar: 1,2-Naphthochinondiazid-4-sulfonylchloride, die das mit einer Phenolverbindung, wie z.B. einem Hydroxybenzophenon, wie Trihydroxybenzophenon und insbesondere 2,3,4-Trihydroxybenzophenon kondensiert wurden; 2,3,4-Trihydroxyphenylpentylketon-1,2-naphthochinon-(2)-diazid-4-sulfonsäuretrisester oder andere Alkylphenone; 2,3,4-Trihydroxy-3'-methoxybenzophenon-1,2-naphthochinon-(2)-diazid-4-sulfonsäuretrisester; 2,3,4-Trihydroxy-3'-methylbenzophenon-1,2-naphthochinon-(2)-diazid-4-sulfonsäuretrisester und 2,3,4-Trihydroxybenzophenon-1,2-naphthochinon-(2)-diazid-4-sulfonsäuretrisester.

Als Vernetzungsmittel dient eine Verbindung, die in Anwesenheit der bei der Belichtung des Diazids mittels aktinischer Strahlung entstehenden Säuremenge und -konzentration zur Vernetzung des beschriebenen Novolak-, oder Polyvinylphenolharzes fähig ist. Zur Einleitung der Vernetzung ist eine Temperatur erforderlich, die ausreicht, um die Diffusion der Säure an das Vernetzungsmittel zu ermöglichen, die jedoch unterhalb der Zersetzungstemperatur des Diazids liegt. Allgemein handelt es sich dabei um Verbindungen, die unter den beschriebenen Säure- und Temperaturverhältnissen ein Carboniumion bilden können.

Als geeignete Verbindungen werden genannt:
1,4-Bis-hydroxymethyl-benzol,
1,3-Bis-hydroxymethyl-benzol,
1,4-Bis-methoxymethyl-benzol,
1,5-Bis-acetoxymethyl-naphthalin,
1,4-Bis-hydroxymethyl-naphthalin,
9,10-Bis-methoxymethyl-anthracen,
2,5-Bis-(hydroxymethyl)-furan,
2,5-Bis-ethoxymethyl-thiophen,
Bis-methoxymethyl-diphenylenoxid,
Bis-methoxymethyl-dimethyldiphenylenoxid,
2,6-Bis-hydroxymethyl-naphthalin,
1,4-Bis-($\alpha$-hydroxymethyl)-benzol,

1,4-Bis-(α-hydroxybenzyl)-benzol,
4,6-Dimethyl-1,3-bis-hydroxymethyl-benzol,
2,5-Dimethyl-1,4-bis-hydroxymethyl-benzol,
2,4,6-Trimethyl-1,3-bis-hydroxymethyl-benzol,
2,4,6-Trimethyl-1,3,5-tris-methoxymethyl-benzol,
2,3,5,6-Tetramethyl-1,4-bis-acetoxymethyl-benzol,
2,4,5,6-Tetramethyl-1,3-bis-ethoxymethyl-benzol,
4,4'-Bis-acetoxymethyl-diphenylmethan,
4,4'-Bis-methoxymethyl-diphenyl,
2-Methyl-1,5-bis-acetoxymethyl-naphthalin,
2-Ethyl-9,10-bis-methoxymethyl-anthracen,
4,6-Diisopropyl,1,3-bis-hydroxymethyl-benzol,
4,6-Diisopropyl-1,3-bis-methoxymethyl-benzol,
4,4'-Bis-acetoxymethyl-diphenylsulfon,
4,4'-Bis-methoxymethyl-benzophenon,
2,6-Bis-hydroxymethyl-4-chlor-phenol,
2,6-Bis-hydroxymethyl-4-methyl-anisol,
1,3-Bis-(3-hydroxymethyl-phenoxy)-propan,
1,3-Dihydroxymethyl-2-methoxy-5-n-hexyl-benzol,
1,3-Dihydroxymethyl-2-ethoxy-5-ethyl-benzol,
1,3-Dihydroxymethyl-2-benzyloxy-5-methoxycarbonyl-benzol,
1,3-Dihydroxymethyl-2-methoxy-5-brom-benzol,
1,3-Dihydroxymethyl-2-methoxy-5-cumyl-benzol,
1,3-Dihydroxymethyl-2-ethoxy-5-methylmercapto-benzol,
1,3-Dihydroxymethyl-2-ethoxy-5-phenoxy-benzol,
1,3-Dihydroxymethyl-2,5-diethoxy-benzol,
1,3-Dihydroxymethyl-2-methoxy-5-benzyl-benzol,
1,3-Dimethoxymethyl-2-methoxy-5-fluor-benzol,
1,3-Dimethoxymethyl-2-ethoxy-5-methoxy-benzol,
1,3-Dimethoxymethyl-2-methoxy-5-phenyl-benzol,
Bis-[2-(4-hydroxymethyl-phenoxy)-ethyl]-ether,
1,3-Dimethoxymethyl-2-ethoxy-5-brom-benzol,
1,3-Diacetoxymethyl-2-ethoxy-5-tert.-butyl-benzol,
1,3-Diacetoxymethyl-2-methoxy-5-phenylmercapto-benzol,
1,3-Diacetoxymethyl-2-methoxy-5-chlor-benzol,
1,3-Diacetoxymethyl-2,5-dimethoxy-benzol,
1,3-Bis-(2-methyl-4-benzyl-6-hydroxymethyl-phenoxy)-propan,
Bis-(3,5-hydroxymethyl-4-hydroxyphenyl)-methan,
Dihydroxymethyl-hydrochinondimethylether,
4-Methoxy-3,5-bis-hydroxymethyl-diphenylether,
Bis-(4-ethoxy-5-methyl-3-hydroxymethyl-phenyl)-sulfon,
4,4'-Bis-hydroxymethyl-diphenylether,
4,4'-Bis-acetoxymethyl-diphenylether,
4,4'-Bis-methoxymethyl-diphenylether,
4,4'-Bis-ethoxymethyl-diphenylether,
2,4'-Bis-methoxymethyl-diphenylether,
2,4,4'-Tris-methoxymethyl-diphenylether,
2,4,2'-Tris-methoxymethyl-diphenylether,
2,4,2',4'-Tetrakis-methoxymethyl-diphenylether,
Bis-methoxymethyl-4,4'-dimethyl-diphenylether,
Bis-methoxymethyl-2,4-dimethoxy-5-methyl-diphenylether,
Bis-methoxymethyl-3,3'-dimethyl-diphenylsulfid,
Bis-methoxymethyl-2,4'-dimethoxy-diphenylsulfid,
2,2'-Bis-(4-hydroxymethyl-phenoxy)-diethylether,
2,2'-Dimethyl-4,4'-bis-hydroxymethyl-diphenylether,
1,3-Bis-(4-methoxymethyl-phenoxy)-benzol,
1,3-Bis-(4-methoxymethyl-phenoxy)-propan,
4,4'-Bis-methoxymethyl-diphenylsulfid,
2,2-Bis-(4-methoxymethyl-phenyl)-propan,
4,4'-Bis-phenoxymethyl-diphenylether,
Bis-methoxymethyl-4-phenoxydiphenylsulfid,
Bis-methoxymethyl-2-isopropyl-5-methyl-diphenylether,
Bis-methoxymethyl-3-brom-4-methoxy-diphenylether,
Bis-methoxymethyl-4-nitro-diphenylether,
2,2'-Bis-(3,5-hydroxymethyl-4-hydroxyphenyl)-propan.

Dazu zählen bevorzugt 2,6-Dimethylol-p-kresol gemäß US-A 4 404 272, 4,4'-Bis-methoxymethyl-diphenylether und Epoxykresolnovolakharze, die der allgemeinen Formel III entsprechen:

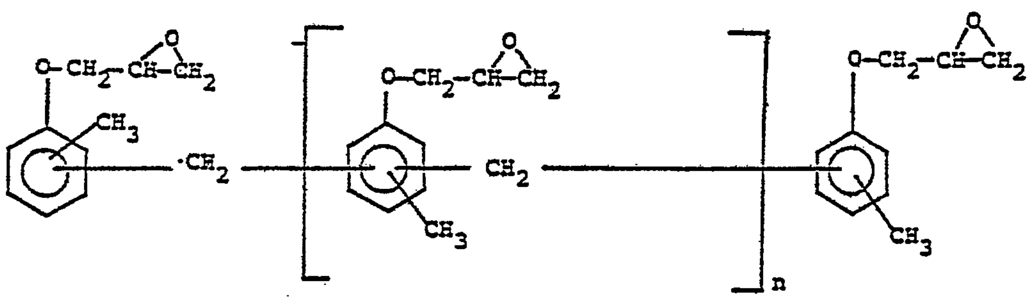

(III)

in der n = 1 bis 1o bedeutet.

Als Vernetzer besonders geeignet sind auch Verbindungen wie 2,5-Bis-(hydroxymethyl)-furan, 2,5-Bis-(ethyloxymethyl)-thiophen, Bis-(3,5-hydroxymethyl-4-hydroxyphenyl)-methan, 4,4-Bis-acetoxymethyl-diphenylether, 1,4-Bis-(α-hydroxybenzyl)-benzol, 2,6-Bis-hydroxymethyl-4-methyl-anisol oder 2,2-Bis-(3,5-hydroxymethyl-4-hydroxyphenyl)-propan, die man allein oder im Gemisch einsetzt.

Zur Herstellung des lichtempfindlichen Gemischs werden die Bestandteile in einem geeigneten Lösemittelgemisch gelöst. Der Anteil des harzartigen Bindemittels am fertigen Gemisch beträgt bevorzugt etwa 75 bis 99 Gewichtsprozent, insbesondere etwa 80 bis 90 Gewichtsprozent, und ganz besonders bevorzugt etwa 82 bis 85 Gewichtsprozent, jeweils bezogen auf den Gesamtfeststoff-, d.h. Nicht-Lösemittelanteil des Gemischs. Der Anteil des Diazids beträgt bevorzugt 1 bis 25 Gewichtsprozent, insbesondere etwa 1 bis 20 Gewichtsprozent, und ganz besonders bevorzugt etwa 10 bis 18 Gewichtsprozent, jeweils bezogen auf die festen Bestandteile des Gemisches, d.h. Nicht-Lösemittelanteil des fertigen Gemischs. Der Anteil des Vernetzungsmittels beträgt bevorzugt etwa 0,5 bis 20 Gewichtsprozent, insbesondere etwa 1 bis 10 Gewichtsprozent, und ganz besonders bevorzugt etwa 3 bis 6 Gewichtsprozent, bezogen auf die festen Bestandteile des Gemisches. Das harzartige Bindemittel, das Vernetzungsmittel und das Diazid werden mit geeigneten Lösemitteln, allein oder im Gemisch, ausgewählt aus z.B. Propylenglykolalkyletheracetat, Butylacetat, Xylol, Ethylenglykolmonoethyletheracetat und vorzugsweise mit Propylenglykolmethyletheracetat vermischt.

Der Lösung aus Bindemittel, lichtempfindlicher Verbindung, Vernetzungsmittel und Lösemittel können noch Zusatzstoffe, wie Farbstoffe, Mittel zur Verhinderung von Streifenbildung, Verlaufsmittel, Weichmacher, Haftvermittler, die Lichtempfindlichkeit erhöhende Stoffe, weitere Lösemittel und Netzmittel, z.B. nichtionische Netzmittel, beigemischt werden.

Beispiele für Farbstoffe, die für die erfindungsgemäßen Photoresistgemische geeignet sind, sind Methylviolett 2B (C.I. 42 535), Kristallviolett (C.I. 42 555), Malachitgrün (C.I. 42 000), Viktoriablau B (C.I. 44 045) und Neutralrot (C.I. 50 040); sie können in einer Menge von 1 bis 10 Gewichtsprozent, bezogen auf die festen Bestandteile des Gemisches, zugesetzt werden. Die Farbstoffzusätze tragen zu einer besseren Bildauflösung bei, da durch sie eine Rückstreuung des Lichts vom Träger verhindert wird.

Mittel zur Verhinderung von Streifenbildung können in einer Menge bis zu 5 Gewichtsprozent, bezogen auf die festen Bestandteile des Gemisches, zugesetzt werden.

Geeignete Weichmacher sind beispielsweise Phosphorsäuretri-(β-chlorethyl)ester, Stearinsäure, Dicampher, Polypropylen, Acetalharze, Phenoxyharze und Alkylharze. Sie werden in einer Menge von 1 bis 10 Gewichtsprozent, bezogen auf die festen Bestandteile des Gemisches, zugesetzt. Durch den Zusatz von Weichmachern werden die Beschichtungseigenschaften des Gemisches verbessert, so daß es möglich ist, eine glatte Schicht gleichmäßiger Dicke aufzutragen.

Zu den geeigneten Haftvermittlern zählen beispielsweise β-(3,4-Epoxycyclohexyl)-ethyltrimethoxysilan, Vinyltrichlorsilan und γ-Aminopropyltriethoxysilan. Sie werden in einer Menge bis zu 4 Gewichtsprozent, bezogen auf die festen Bestandteile des Gemisches, zugesetzt.

Zur Erhöhung der Lichtempfindlichkeit können beispielsweise Pikrinsäure, Nicotinsäure oder Nitrozimtsäure in einer Menge von bis zu 20 Gewichtsprozent, bezogen auf die festen Bestandteile des Gemisches, zugesetzt werden. Durch diese Stoffe wird die Löslichkeit der lichtempfindlichen Schicht sowohl an den belichteten als auch an den unbelichteten Stellen erhöht. Diese Stoffe werden daher in solchen Fällen beigemischt, wo vor allem auf eine rasche Entwicklung Wert gelegt wird, auch wenn dies auf Kosten des Kontrastes geht. Die Einbuße an Kontrast rührt daher, daß nach dem Zusatz von die Lichtempfindlichkeit steigernden Mitteln der Entwickler nicht nur die belichteten Stellen der lichtempfindlichen Schicht schneller löst, sondern daß auch an den unbelichteten Stellen ein erhöhter Schichtverlust eintritt.

Der Lösemittelanteil des fertigen Gemisches beträgt bis zu 95 Gewichtsprozent, bezogen auf das Gesamtgewicht.

Zu den nichtionischen Netzmitteln, die eingesetzt werden können, zählen zum Beispiel Nonylphenoxypoly(ethylenoxy)ethanol, Octylphenoxy(ethylenoxy)ethanol und Dinonylphenoxypoly(ethylenoxy)ethanol.

Sie werden in einer Menge von bis zu 10 Gewichtsprozent, bezogen auf das Gesamtfeststoffgewicht, verwendet.

Die fertig zubereitete Photoresistlösung wird mit Hilfe gebräuchlicher Verfahren, wie Tauchen, Sprühen oder Schleudern, auf einen geeigneten Schichtträger aufgebracht. Wird beispielsweise im Schleuderverfahren beschichtet, wird der Feststoffgehalt der Photoresistlösung auf einen bestimmten Prozentsatz eingestellt, um in Abhängigkeit von der verwendeten Schleudervorrichtung und der Aufschleuderzeit die jeweils gewünschte Schichtdicke zu erzielen.

Als Materialien für den Schichtträger kommen zum Beispiel Silicium, Aluminium oder polymere Harze, Siliciumdioxid, dotiertes Siliciumdioxid, Siliciumnitrid, Polysilicium, Tantal, Kupfer, Keramik und Aluminium-Kupfer-Mischungen in Frage.

Photoresistschichten der beschriebenen Art eignen sich besonders gut zum Aufbringen auf Siliciumwafer mit thermisch erzeugten Siliciumdioxidschichten, wie sie bei der Produktion von Mikroprozessoren und anderen Halbleiterbauelementen verwendet werden. Es kann auch ein Schichtträger aus Aluminium mit einer Aluminiumoxidschicht verwendet werden.

Außerdem sind zahlreiche polymere Harze, insbesondere transparente Polymere, wie zum Beispiel Polyester, als Schichtträger geeignet.

Nach dem Auftragen der Lösung auf den Schichtträger wird der Träger einer Vortrocknung bei etwa 20°C bis 100°C unterworfen. Diese Wärmebehandlung erfolgt, um die Restlösemittelkonzentration im Photoresist zu verringern und zu steuern, ohne daß es dabei zu einer merklichen thermischen Zersetzung der lichtempfindlichen Verbindung kommt. Es wird im allgemeinen angestrebt, den Gehalt an Lösemitteln auf ein Minimum zu senken, und diese erste Wärmebehandlung wird daher so lange fortgeführt, bis die Lösemittel praktisch vollständig verdampft sind und eine dünne Schicht aus Photoresistgemisch, deren Dicke etwa 1 µm beträgt, auf dem Schichtträger zurückbleibt. Bevorzugt liegt die Temperatur bei dieser Behandlung zwischen etwa 50 und 90°C, insbesondere zwischen etwa 70 und 90°C. Dieser Behandlungsschritt ist dann beendet, wenn sich der Lösemittelanteil nicht mehr nennenswert verringert. Die Wahl der jeweiligen Temperatur und Zeitdauer hängt von den vom Anwender gewünschten Resisteigenschaften, der verwendeten Ausrüstung und den für kommerzielle Zwecke erwünschten Beschichtungszeiten ab.

Bei einer Behandlung mit Hilfe von Heizplatten, sogenannten "Hot Plates", ist eine Dauer von bis zu 3 Minuten, bevorzugt bis zu 1 Minute, wirtschaftlich sinnvoll. Beispielsweise kann die Vortrocknung innerhalb von 30 Sekunden bei 90°C durchgeführt werden. Der Schichtträger kann anschließend mit aktinischer Strahlung, insbesondere mit UV-Strahlung, durch geeignete Masken, Negative, Schablonen usw., bildmäßig belichtet werden. Unter dem Begriff der aktinischen Strahlung sollen auch kurzwelliges sichtbares Licht, Elektronenstrahlen, Ionenstrahlen oder Röntgenstrahlen verstanden werden.

An die Belichtung schließt sich das Tempern an, eine zweite Wärmebehandlung. Sie findet bei einer Temperatur im Bereich zwischen etwa 95 und 160°C, bevorzugt zwischen 95 und 150°C, insbesondere zwischen 112 und 120°C, statt. Die Behandlung wird mit einem Heizplattensystem durchgeführt. Ihre Dauer liegt zwischen etwa 10 Sekunden und mehr, in welcher Zeit die Vernetzung des Harzes erfolgt. Im allgemeinen übersteigt sie nicht eine Zeit von etwa 120 Sekunden. Vorzugsweise sind dies etwa 10 bis 90 Sekunden, insbesondere etwa 30 bis 90 Sekunden, sehr vorteilhaft kann auch eine Dauer von etwa 15 bis 45 Sekunden sein. Die Behandlung kann die angegebene Zeit auch überschreiten, doch führt dies im allgemeinen nicht zu einer weiteren Verbesserung des Ergebnisses. Die benötigte Zeit hängt jeweils von der Zusammensetzung des Photoresistgemischs und dem Schichtträger ab. Durch das Erwärmen findet die Diffusion der durch Belichten erzeugten Säure zu der vernetzenden Komponente statt. Infolge des Temperns wird außerdem das Diazid in eine Carbonsäure enthaltende Verbindung umgewandelt, wie z.B. Indencarbonsäure, die in wäßrig-alkalischen Lösungen löslich ist.

Temperatur und Dauer der Vortrocknung und des Temperns, d.h. der ersten und zweiten Wärmebehandlung, werden aufgrund der vom Anwender gewünschten Eigenschaften gewählt und auf den jeweils besten Wert eingestellt.

Falls erwünscht, kann man nach dem Tempern und Abkühlen des Materials die Schicht einer ganzflächigen aktinischen Bestrahlung aussetzen.

Als nächstes werden die mit dem Photoresistgemisch beschichteten und belichteten Schichtträger in eine geeignete Entwicklerlösung getaucht. Die Lösung wird vorzugsweise stark bewegt, was zum Beispiel durch Durchblasen von Stickstoff erfolgen kann. Die Schichtträger bleiben so lange in der Entwicklerlösung, bis die Photoresistschicht an den unbelichteten Stellen ganz oder doch fast ganz abgelöst ist. Als Entwickler werden vorzugsweise die bekannten wäßrig-alkalischen Entwicklerlösungen verwendet, wie zum Beispiel Natriumhydroxid- und Tetramethylammoniumhydroxidlösungen.

Im Anschluß an die Entwicklung kann noch eine weitere Wärmebehandlung der beschichteten Wafers durchgeführt werden, um die Haftung der Schicht und ihre chemische Resistenz gegen Ätzlösungen und andere Substanzen zu erhöhen. Die sich an die Entwicklung anschließende Wärmebehandlung ist beispielsweise eine Behandlung des Schichtträgers und der darauf aufgebrachten Schicht bei Temperaturen unterhalb des Erweichungspunktes der Beschichtung.

Für industrielle Anwendungen, insbesondere bei der Herstellung von Halbleiterbauelementen auf Siliciumträgern mit einer Siliciumdioxidschicht können die entwickelten Träger mit einer gepufferten Ätzlösung auf der Basis von Flußsäure behandelt werden. Die erfindungsgemäßen Photoresistgemische sind

gegen derartige Ätzlösungen auf Säurebasis resistent und gewährleisten einen wirksamen Schutz der unbelichteten, mit dem Photoresistgemisch beschichteten Stellen des Trägers.

Anhand der folgenden Beispiele sollen die Vorteile des erfindungsgemäßen Herstellungsverfahrens und seiner Anwendung eingehend erläutert werden. Die Erfindung soll jedoch nicht auf diese Beispiele und die darin angegebenen Bedingungen, Parameter oder Werte beschränkt sein.

Beispiel 1

Das verwendete Photoresistgemisch besteht aus einer Lösung in Propylenglykolmonomethyletheracetat, die einen Feststoffgehalt von 5 Gewichtsprozent Dimethylol-p-kresol, 6 Gewichtsprozent 2,3,4-Trihydroxy-3'-methylbenzophenon-1,2-naphthochinon-2-diazid-4-sulfonsäuretrisester und 89 Gewichtsprozent Kresol-Novolakharz aufweist.

Mit diesem Gemisch werden Siliciumwafer bei einer Geschwindigkeit von 4000 U/min schleuderbeschichtet und 30 Minuten in einem Umluftofen bei 90°C vorgetrocknet. In einem Projektionsbelichtungsgerät 220 Micralign der Firma Perkin Elmer (USA) wird mittels aktinischer Strahlung durch eine Photomaske hindurch belichtet, die ein Testbild zum Prüfen der Bildauflösung enthält. Es wird die Blendenöffnung Nr. 4 gewählt und die Belichtungsgeschwindigkeit zwischen 200 und 400 willkürlich festgelegten Einheiten variiert. Diese unterschiedlichen Belichtungsgeschwindigkeiten (jede Belichtungsgeschwindigkeit steht für einen separaten Test) entsprechen 20 bis 10 mJ/cm$^2$, gemessen mit Hilfe eines Intensitätsmeßgerätes der Firma OAI (USA) für den Wellenlängenbereich von 365 bis 436 nm. Die Photomaske besteht aus einem Testbild zum Prüfen der Bildauflösung, das sowohl einzelne Linien, als auch Paare gleicher Linien- und Abstandsbreite aufweist. Die Breite der einzelnen Bildelemente beträgt 1,0 bis 3,0 µm, wobei die Zunahme jeweils 0,25 µm beträgt. Im Anschluß an die Belichtung werden die Wafer mittels eines Heizplattensystems der Firma MTI Inc. (USA) nacheinander einer Wärmebehandlung unterworfen. Die Temperaturen betragen 110 bis 150°C, die Behandlungsdauer beträgt bis zu 60 Sekunden. Unter einem optischen Mikroskop mit monochromatischer Beleuchtung von 520 nm ist nun ein Reliefbild sichtbar.

Die belichteten und wärmebehandelten Wafer werden in einem Tauchverfahren 3 Minuten lang unter leichter Bewegung des Entwicklerbades mit einem Entwickler der Marke "AZ 433 MIF Developer", (0,33 n Tetramethylammoniumhydroxidlösung, Hersteller American Hoechst Corporation, USA) entwickelt, mit entionisiertem Wasser abgespült und trockengeschleudert. Im Anschluß daran werden sie unter einem Raster-Elektronen-Mikroskop mit 10 000-facher Vergrößerung untersucht. Es wird festgestellt, daß Öffnungen von 1 µm und größer deutlich als einwandfrei aufentwickelt zu sehen sind.

Beispiel 2

Beispiel 1 wurde wiederholt unter der Abänderung, daß das Photoresistgemisch aus einer Lösung in Propylenglykolmonomethyletheracetat besteht, die einen Feststoffgehalt von 5 Gewichtsprozent 2,6-Dimethylol-4-kresol, 6 Gewichtsprozent 2,3,4-Trihydroxy-3'-methoxybenzophenon-1,2-naphthochinon-(2)-diazid-4-sulfonsäuretrisester und 89 Gewichtsprozent Kresol-Novolakharz aufweist.

Es wurden vergleichbar gute Ergebnisse wie in Beispiel 1 erzielt.

Beispiel 3

Beispiel 1 wurde wiederholt unter der Abänderung, daß das Photoresistgemisch aus einer Lösung in Propylenglykolmonomethyletheracetat besteht, die einen Feststoffgehalt von 5 Gewichtsprozent 2,6-Dimethylol-4-kresol, 6 Gewichtsprozent 2,3,4-Trihydroxy-phenylpentyl-keton-1,2-naphthochinon-(2)-diazid-4-sulfonsäuretrisester und 89 Gewichtsprozent Kresol-Novolakharz aufweist.

Es wurden vergleichbar gute Ergebnisse wie in Beispiel 1 erzielt.

Beispiel 4

Beispiel 1 wurde wiederholt unter der Abänderung, daß das Photoresistgemisch aus einer Lösung in Propylenglykolmonomethylethercetat besteht, die einen Feststoffgehalt von 5 Gewichtsprozent 4,4'-Bis-methoxy-methyl-diphenylether, 6 Gewichtsprozent 2,3,4-Trihydroxy-benzophenon-1,2-naphthochinon-(2)-diazid-4-sulfonsäuretrisester und 89 Gewichtsprozent Kresol-Novolakharz aufweist.

Es wurden vergleichbar gute Ergebnisse wie in Beispiel 1 erzielt.

Beispiel 5

Beispiel 1 wurde wiederholt unter der Abänderung, daß das Photoresistgemisch aus einer Lösung in Propylenglykolmonomethyletheracetat besteht, die einen Feststoffgehalt von 5 Gewichtsprozent 4,4'-Bis-methoxymethyl-diphenylether, 6 Gewichtsprozent 2,3,4-Trihydroxy-3'-methylbenzophenon-1,2-naphthochinon-(2)-diazid-4-sulfonsäuretrisester und 89 Gewichtsprozent Kresol-Novolakharz aufweist.

Es wurden vergleichbar gute Ergebnisse wie in Beispiel 1 erzielt.

Beispiel 6

Beispiel 1 wurde wiederholt unter der Abänderung, daß das Photoresistgemisch aus einer Lösung in Propylenglykolmonomethylethercetat besteht, die einen Feststoffgehalt von 5 Gewichtsprozent 4,4'-Bis-methoxymethyl-diphenylether, 6 Gewichtsprozent 2,3,4-Trihydroxy-3'-methoxybenzophenon-1,2-naphthochinon-(2)-diazid-4-sulfonsäuretrisester und 89 Gewichtsprozent Kresol-Novolakharz aufweist.
Es wurden vergleichbar gute Ergebnisse wie in Beispiel 1 erzielt.

Beispiel 7

Beispiel 1 wurde wiederholt unter der Abänderung, daß das Photoresistgemisch aus einer Lösung in Propylenglykolmonomethyletheracetat besteht, die einen Feststoffgehalt von 5 Gewichtsprozent 4,4'-Bis-methoxymethyl-diphenylether, 6 Gewichtsprozent 2,3,4-Trihydroxy-phenylpentylketon-1,2-naphthochinon-(2)-diazid-4-sulfonsäuretrisester und 89 Gewichtsprozent Kresol-Novolakharz aufweist.
Es wurden vergleichbar gute Ergebnisse wie in Beispiel 1 erzielt.

Beispiel 8

Beispiel 1 wurde wiederholt unter der Abänderung, daß das Photoresistgemisch aus einer Lösung in Propylenglykolmonomethyletheracetat besteht, die einen Feststoffgehalt von 5 Gewichtsprozent Epoxykresol-Novolakharz, 6 Gewichtsprozent 2,3,4-Trihydroxy-benzophenon-1,2-naphthochinon-(2)-diazid-4-sulfonsäuretrisester und 89 Gewichtsprozent Kresol-Novolakharz aufweist.
Es wurden vergleichbar gute Ergebnisse wie in Beispiel 1 erzielt.

Beispiel 9 bis 14

Beispiel 1 wurde wiederholt unter der Abänderung, daß das Photoresistgemisch aus einer Lösung in Propylenglykolmonomethyletheracetat besteht, die einen Feststoffgehalt von 89 Gewichtsprozent Kresol-Novolakharz und folgende Substanzen, in Gewichtsprozent, aufweist:

9. 5% 2,5-Bis-(hydroxymethyl)-furan,
6% 2,3,4-Trihydroxy-3'-methylbenzophenon-1,2-naphthochinon-2-diazid-4-sulfonsäuretrisester;
10. 5% 2,5-Bis-(ethoxymethyl)-thiophen,
6% 2,3,4-Trihydroxy-3'-methylbenzophenon-1,2,-naphthochinon-2-diazid-4-sulfonsäuretrisester;
11. 5% Bis-(3,5-hydroxymethyl-4-hydroxyphenyl)-methan,
6% 2,3,4-Trihydroxy-3'-methylbenzophenon-1,2-naphthochinon-2-diazid-4-sulfonsäuretrisester;
12. 5% 4,4'-Bis-acetoxymethyl-diphenylether,
6% 2,3,4-Trihydroxy-benzophenon-1,2-naphthochinon-2-diazid-4-sulfonsäuretrisester;
13. 5% 1,4-Bis-(-hydroxybenzyl)-benzol,
6% 2,3,4-Trihydroxy-benzophenon-1,2-naphthochinon-2-diazid-4-sulfonsäuretrisester;
14. 2,5% 2,6-Bis-hydroxymethyl-4-methyl-anisol,
2,5% 2,2-Bis-(3,5-hydroxymethyl-4-hydroxyphenyl)propan,
6% 2,3,4-Trihydroxy-benzophenon-1,2-naphthochinon-2-diazid-4-sulfonsäuretrisester;

Es wurden vergleichbar gute Ergebnisse wie in Beispiel 1 erzielt.

**Patentansprüche**

1. Verfahren zur Herstellung negativer Bilder aus einem positiv arbeitenden Photoresist mit folgenden Verfahrensschritten:
A) Herstellung eines lichtempfindlichen Gemisches, bestehend aus
a) etwa 1 bis 25 Gewichtsprozent, bezogen auf die festen Bestandteile des Gemisches, einer lichtempfindlichen Verbindung der allgemeinen Formel (I)

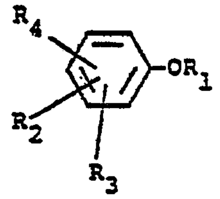

(I)

worin
$R_1$ – 1,2-Benzochinon-(2)-diazid-4-sulfonyl-,

1,2-Naphthochinon-(2)-diazid-4-sulfonyl-
oder
1,2-Anthrachinon-(2)-diazid-4-sulfonyl,
$R_2$, $R_3$, $R_4$ – gleich oder verschieden sind und Wasserstoff, $R_5$, $-OR_6$ oder $-CO-R_7$,
$R_5$ und $R_7$ – Alkyl, Aryl oder Aralkyl und
$R_6$ – Wasserstoff, Alkyl, Aryl, Aralkyl oder $R_1$ bedeuten.
b) etwa 75 bis 99 Gewichtsprozent, bezogen auf die festen Bestandteile des Gemisches, eines Novolaks oder Polyvinylphenol-, vorzugsweise Poly-p-vinylphenol-Harzes,
c) etwa 0,5 bis etwa 20 Gewichtsprozent, bezogen auf die festen Bestandteile des Gemisches, aus einem Vernetzer besteht, der in Gegenwart von Säure, die aus den Lichtzersetzungsprodukten entsteht, die Fähigkeit besitzt, das Harz nach b) zu vernetzen und
d) einer ausreichenden Menge an Lösungsmittel, um die vorstehenden Verbindungen zu lösen,
B) Beschichten eines Schichtträgers mit dem lichtempfindlichen Gemisch nach A),
C) Vortrocknen der Lösung auf Temperaturen im Bereich von 20 bis 100°C, bis das Lösungsmittel im wesentlichen verdunstet ist,
D) bildliches Belichten der lichtempfindlichen Schicht mit aktinischer Strahlung,
E) Tempern der belichteten Schicht auf Temperaturen im Bereich von wenigstens 95°C bis etwa 160°C innerhalb von 10 Sekunden und mehr, in welcher Zeit die Vernetzung erfolgt,
F) Entfernen der unbelichteten Bereiche der Schicht mit einem alkalischen Entwickler.

2. Verfahren nach Anspruch 1, dadurch gekennzeichnet, daß man als lichtempfindliche Verbindung 2,3,4-Trihydroxybenzophenon-1,2-naphthochinon-(2)-diazid-4-sulfonsäuretrisester verwendet.

3. Verfahren nach Anspruch 1, dadurch gekennzeichnet, daß man als Vernetzer eine Verbindung der allgemeinen Formel (II)

$(R_1O-CHR_3)_n-A-(CHR_3-OR_2)_m$ (II)

verwendet,
in der A $-B-$ oder $-B-Y-B-$ ist und
B – einen gegebenenfalls substituierten einkernigen oder annellierten mehrkernigen aromatischen Kohlenwasserstoff oder eine Sauerstoff oder Schwefel enthaltende heterocyclische aromatische Verbindung darstellt,
Y – eine Einfachbindung, $C_1$ bis $C_4$-Alkylen oder Alkylendioxy, deren Ketten durch Sauerstoffatome unterbochen sein können, $-O-$, $-S-$, $-SO_2-$, $-CO-$, $-CO_2-$, $-O-CO_2-$, $-CONH-$ oder Phenylendioxy bedeutet,
$R_1$ und $R_2$ Wasserstoff, $C_1$ bis $C_6$-Alkyl, Cycloalkyl-, gegebenenfalls substituiertes Aryl, Aralkyl oder Acyl ist,
$R_3$ – Wasserstoff, $C_1$ bis $C_4$-Alkyl oder gegebenenfalls substituiertes Phenyl,
n – 1 bis 3 und
m – 0 bis 3, wobei n+m mindestens 2 ist,
bedeuten.

4. Verfahren nach Anspruch 1, dadurch gekennzeichnet, daß man als Vernetzer 2,6-Dimethylol-4-kresol verwendet.

5. Verfahren nach Anspruch 1, dadurch gekennzeichnet, daß man als Vernetzer 4,4'-Bis-methoxymethyl-diphenylether verwendet.

6. Verfahren nach Anspruch 1, dadurch gekennzeichent, daß man als Vernetzer Epoxykresol-Novolakharz verwendet.

7. Verfahren nach Anspruch 1 oder 3, dadurch gekennzeichnet, daß man als Vernetzer 2,5-Bis-(hydroxymethyl)-furan, 2,5-Bis-(ethyloxymethyl)-thiophen, 2,5-Bis-(3,5-hydroxymethyl-4-hydroxyphenyl)-methan, 4,4-Bis-acetoxymethyl-diphenylether, 1,4-Bis-(-hydroxybenzyl)-benzol, 2,6-Bis-hydroxymethyl-4-methyl-anisol oder 2,2-Bis-(3,5-hydroxymethyl-4-hydroxyphenyl)-propan allein oder im Gemisch verwendet.

8. Verfahren nach Anspruch 1, dadurch gekennzeichnet, daß man als Lösungsmittel Propylenglykolmonoalkyletheracetat verwendet.

9. Verfahren nach Anspruch 1, dadurch gekennzeichnet, daß man das Tempern bei Temperaturen im Bereich von etwa 95 bis etwa 150°C durchführt.

10. Verfahren nach Anspruch 1 oder 9, dadurch gekennzeichnet, daß man das Tempern innerhalb von etwa 10 bis etwa 90 Sekunden durchführt.

11. Verfahren nach Anspruch 1, dadurch gekennzeichnet, daß man einen wäßrig-alkalischen Entwickler verwendet.

12. Verfahren nach Anspruch 1 oder 11, dadurch gekennzeichnet, daß man als Entwickler eine wäßrige Lösung von Natriumhydroxid und/oder Tetramethylammoniumhydroxid verwendet.

13. Verfahren nach Anspruch 1, dadurch gekennzeichnet, daß man einen Novolak und 2,6-Dimethylol-4-kresol als Vernetzer verwendet, und das Tempern bei einer Temperatur im Bereich von 112 bis 120 °C innerhalb von 90 Sekunden durchführt und für die Entwicklung eine wäßrige Lösung von Natriumhydroxid und/oder Tetramethylammoniumhydroxid einsetzt.

**Revendications**

1. Procédé pour l'obtention d'images négatives à partir d'un photoresist travaillant en positif, comportant les étapes de processus suivantes:

A) préparation d'un mélange photosensible composé de

a) environ 1 à 25% en poids, par rapport aux composants solides du mélange, d'un composé photosensible de formule générale (I)

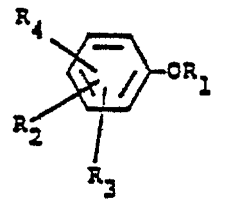

(I)

dans laquelle

$R_1$ représente un radical

1,2-benzoquinone-(2)-diazide-4-sulfonyle,

1,2-naphtoquinone-(2)-diazide-4-sulfonyle ou

1,2-anthraquinone-(2)-diazide-4-sulfonyle;

$R_2$, $R_3$, $R_4$ sont identiques ou différents, et représentent un atome d'hydrogène ou $R_5$, $-OR_6$ ou $-CO-R_7$;

$R_5$ et $R_7$ représentent un groupe alkyle, aryle ou aralkyle; et

$R_6$ représente un atome s'hydrogène ou un groupe alkyle, aryle, aralkyle ou $R_1$;

b) environ 75 à 99% en poids, par rapport aux oomposants solides du mélange, d'une Novolaque et/ou d'une résine polyvinylphénolique, en particulier poly-p-vinyl-phénolique;

c) environ 0,5 à environ 20% en poids, par rapport aux composants solides du mélange, d'un agent de réticulation qui a la faculté de réticuler la résine selon b) en présence d'acide formé à partir des produits de photodécomposition; et

d) une quantité suffisante de solvant pour dissoudre les composés précédents;

B) revêtement d'un support de couche avec le mélange photosensible selon A);

C) pré-séchage de la solution à des températures dans la plage de 20 à 100°C, jusqu'à ce que le solvant soit pratiquement évaporé;

D) exposition selon l'image de la couche photosensible au moyen d'un rayonnement actinique;

E) recuit de la couche exposée, à des températures dans la plage d'au moins 95°C à environ 160°C, en l'espace de 10 secondes et plus, durée pendant laquelle s'effectue la réticulation;

F) élimination des zones non exposées de la couche à l'aide d'un révélateur alcalin.

2. Procédé selon la revendication 1, caractérisé en ce que l'on utilise en tant que composé photosensible le triester 1,2-naphtoquinone-(2)-diazide-4-sulfonique de 2,3,4-trihydroxy-benzophénone.

3. Procédé selon la revendication 1, caractérisé en ce que l'on utilise en tant qu'agent de réticulation un composé de formule générale (II)

$(R_1O-CHR_3)_n-A-(CHR_3-OR_2)_m$ (II)

dans laquelle

A = –B– ou –B–Y–B– et

B représente un hydrocarbure aromatique monocyclique ou polycyclique condensé, éventuellement substitué, ou un composé aromatique hétérocyclique contenant un atome d'oxygène ou de soufre;

Y représente une liaison simple ou un groupe alkylène ou alkylènedioxy en $C_1-C_4$, dont les chaînes peuvent être interrompues par des atomes d'oxygène, –O–, –S–, $-SO_2-$, –CO–, $-CO_2-$, $-O-CO_2-$, –CONH– ou un groupe phénylènedioxy;

$R_1$ et $R_2$ représentent un atome d'hydrogène ou un groupe alkyle en $C_1-C_6$, cycloalkyle, aryle éventuellement substitué, aralkyle ou acyle;

$R_3$ représente un atome d'hydrogène ou un groupe alkyle en $C_1-C_4$ ou un groupe phényle éventuellement substitué;

n vaut de 1 à 3, et

m vaut de 0 à 3, n+m étant au moins égal à 2.

4. Procédé selon la revendication 1, caractérisé en ce que l'on utilise en tant qu'agent de réticulation le 2,6-diméthylol-4-crésol.

5. Procédé selon la revendication 1, caractérisé en ce que l'on utilise en tant qu'agent de réticulation l'éther 4,4'-bis-méthoxyméthyl-diphénylique.

6. Procédé selon la revendication 1, caractérisé en ce que l'on utilise en tant qu'agent de réticulation une résine Novolaque à base d'époxycrésol.

7. Procédé selon la revendication 1 ou 3, caractérisé en ce que l'on utilise en tant qu'agent de réticulation le 2,5-bis-(hydroxyméthyl)-furanne, le 2,5-bis-(éthoxyméthyl)-thiophène, le 2,5-bis-(3,5-hydroxyméthyl-4-hydroxyphényl)-méthane, l'éther 4,4'-bis-acétoxyméthyl-diphénylique, le 1,4-bis-α–hydroxybenzyl)-benzène, le 2,6-bis-hydroxyméthyl-4-méthyl-anisole ou le 2,2-bis-(3,5-hydroxyméthyl-4-hydroxyphényl)-propane, seuls ou en mélange.

8. Procédé selon la revendication 1, caractérisé en ce que l'on utilise en tant que solvant un acétate d'éther monoalkylique de propylèneglycol.

9. Procédé selon la revendication 1, caractérisé en ce que l'on effectue le recuit à des températures dans la plage d'environ 95 à environ 150°C.

10. Procédé selon la revendication 1 ou 9, caractérisé en ce que l'on effectue le recuit en l'espace d'environ 10 à environ 90 secondes.

11. Procédé selon la revendication 1, caractérisé en ce que l'on utilise un révélateur aqueux-alcalin.

12. Procédé selon la revendication 1 ou 11, caractérisé en ce que l'on utilise en tant que révélateur une solution aqueuse d'hydroxyde de sodium et/ou d'hydroxyde de tétraméthylammonium.

13. Procédé selon la revendication 1, caractérisé en ce que l'on utilise une Novolaque et du 2,6-diméthylol-4-crésol en tant qu'agent de réticulation, et on effectue le recuit en l'espace de 90 secondes à une température dans la plage de 112 à 120°C, et on utilise pour le développement une solution aqueuse d'hydroxyde de sodium et/ou d'hydroxyde de tétraméthylammonium.

## Claims

1. Process for producing negative images from a positive photoresist, by means of the following process steps:

A) The preparation of a photosensitive mixture comprising

a) about 1 to 25 per cent by weight, based on the solid components of the mixture, of a photosensitive compound of the general formula (I)

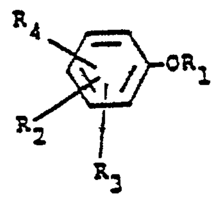

(I)

in which

$R_1$ denotes 2-diazo-1,2-benzoquinone-4-sulphonyl, 2-diazo-1,2-naphthoquinone-4-sulphonyl or 2-diazo-1,2-anthraquinone-4-sulphonyl,

$R_2$, $R_3$ and $R_4$ are identical or different and denote hydrogen, $R_5$, $-OR_6$ or $-CO-R_7$,

$R_5$ and $R_7$ denote alkyl, aryl or aralkyl, and

$R_6$ denotes hydrogen, alkyl, aryl, aralkyl or $R_1$,

b) about 75 to 99 per cent by weight, based on the solid components of the mixture, of a novolak or a polyvinylphenol, preferably poly-p-vinylphenol resin,

c) about 0.5 to about 20 per cent by weight, based on the solid components of the mixture, of a crosslinking agent which is capable of crosslinking the resin as in b) in the presence of acid produced from the photodecomposition products, and

d) a sufficient amount of solvent to dissolve the above compounds,

B) the coating of a coating base with the photosensitive mixture as in A),

C) the pre-drying of the solution at temperatures in the range 20 to 100°C until the solvent has essentially evaporated,

D) image exposure of the photosensitive coating with actinic irradiation,

E) the conditioning of the exposed coating at temperatures in the range from at least 95°C to about 160°C over the course of 10 seconds and more, during which time the crosslinking takes place,

F) the removal of the non-exposed areas of the coating using an alkaline developer.

2. Process according to Claim 1, characterized in that the photosensitive compound used is a triester of 2,3,4-trihydroxybenzophenone-2-diazo-1,2-naphthoquinone-4-sulphonic acid.

3. Process according to Claim 1, characterized in that the crosslinking agent used is a compound of the general formula (II)

$(R_1O-CHR_3)_n-A-(CHR_3-OR_2)m$ (II)

in which

A is –B– or –B–Y–B–, and

B represents an optionally substituted, mononuclear aromatic hydrocarbon or a fused multinuclear aromatic hydrocarbon or a heterocyclic aromatic compound containing oxygen or sulphur,
Y denotes a single bond, $C_1$ to $C_4$–alkylene or alkylenedioxy whose chains may be interrupted by oxygen atoms, or denotes –O–, –S–, $–SO_2–$, –CO–, $–CO_2–$, $–O–CO_2–$, –CONH– or phenylenedioxy,
$R_1$ and $R_2$ is (sic) hydrogen, $C_1$ to $C_6$-alkyl, cycloalkyl, optionally substituted aryl, aralkyl or acyl,
m denotes 0 to 3, where n+m is at least 2.

4. Process according to Claim 1, characterized in that the crosslinking agent used is 2,6-dimethylol-4-cresol.

5. Process according to Claim 1, characterized in that the crosslinking agent used is 4,4'-bis-methoxymethyl-diphenyl ether.

6. Process according to Claim 1, characterized in that the crosslinking agent used is epoxycresol novolak resin.

7. Process according to Claim 1 or 3, characterized in that the crosslinking agent used is 2,5-bis-(hydroxymethyl)-furan, 2,5-bis-(ethoxymethyl)-thiophene, 2,5-bis-(3,5-hydroxymethyl-4-hydroxyphenyl)-methane, 4,4'-bis-acetoxymethyl-diphenyl ether, 1,4-bis-(α-hydroxybenzyl)-benzene (sic), 2,6-bis-hydroxymethyl-4-methyl-anisole or 2,2-bis-(3,5-hydroxymethyl-4-hydroxyphenyl)-propane, alone or in a mixture.

8. Process according to Claim 1, characterized in that the solvent used is propylene glycol monoalkyl ether acetate.

9. Process according to Claim 1, characterized in that the conditioning is carried out at temperatures in the range from about 95 to about 150°C.

10. Process according to Claim 1 or 9, characterized in that the conditioning is carried out over the course of about 10 to about 90 seconds.

11. Process according to Claim 1, characterized in that an aqueous alkaline developer is used.

12. Process according to Claim 1 or 11, characterized in that the developer used is an aqueous solution of sodium hydroxide and/or tetramethylammonium hydroxide.

13. Process according to Claim 1, characterized in that a novolak and 2,6-dimethylol-4-cresol are used as the crosslinking agents, and the conditioning is carried out at a temperature in the range 112 to 120°C over the course of 90 seconds, and an aqueous solution of sodium hydroxide and/or tetramethylammonium hydroxide is employed for the development.